Europäisches Patentamt

European Patent Office

Office européen des brevets

(11) Publication number: **0 540 799 A1**

# EUROPEAN PATENT APPLICATION

(21) Application number: 91810848.1

(22) Date of filing: 04.11.91

(51) Int. Cl.5: **H01L 33/00, H01S 3/19**

Amended claims in accordance with Rule 86 (2) EPC.

(43) Date of publication of application:
**12.05.93 Bulletin 93/19**

(84) Designated Contracting States:
**DE FR GB IT**

(71) Applicant: **International Business Machines Corporation**
**Old Orchard Road**
**Armonk, N.Y. 10504(US)**

(72) Inventor: **Bona, Gian-Luca, Dr.**
**Gerbiweg 9**
**CH-8910 Affoltern a. Albis(CH)**
Inventor: **Buchan, Nicholas, Dr.**
**Schlimbergstrasse 63**
**CH-8802 Kilchberg(CH)**
Inventor: **Heuberger, Willi**
**Reidholzstrasse 26a**
**CH-8805 Richterswil(CH)**
Inventor: **Röntgen, Peter, Dr.**
**Sonnenbergstrasse 40**
**CH-8800 Thalwil(CH)**

(74) Representative: **Barth, Carl Otto et al**
**IBM Corporation Säumerstrasse 4**
**CH-8803 Rüschlikon (CH)**

(54) **Improved AlGaInP diodes emitting visible light.**

(57) The invention concerns AlGaInP/GaInP visible laser diodes and LEDs with improved maximum output power. This is achieved by embedding the active region of the diode (30), e.g a GaInP active layer (35), between very thin p- and n-doped AlGaInP barrier layers (34.1, 34.2) and thick p- and n-doped AlGaAs cladding layers (33, 36). The inventive barrier layers (34.1, 34.2) are employed to avoid tunneling and spill over of carriers from the active region (35) into the cladding (33, 36). These barrier layers (34.1, 34.2) can be very thin thus allowing bandgap engineering and providing for barriers with low defect density. In addition the low resistance of the AlGaAs cladding reduces the thermal and electrical resistances of the device.

FIG. 3A

TECHNICAL FIELD

In some optoelectronic applications there is a special need for visible laser diodes lasing with a wavelength between 600 nm and 700 nm, and visible light emitting diodes (LEDs). The performance and reliability of these devices have to meet special requirements as there are e.g. high output power, continuous wave operation, low thermal and electrical resistance. Laser diodes consisting of AlGaInP/GaInP allow to fabricate lasers emitting lightwaves having wavelength lower than 700 nm. Different AlGaInP/GaInP device structures have been reported qualifying these types of lasers and LEDs to be the most promising ones for several future optoelectronic applications.

BACKGROUND OF THE INVENTION

AlGaInP/GaInP visible lasers and light emitting diodes are light sources which could be utilized for various optoelectronic applications including high−density optical disks, laser printers, plastic fiber com−munication, bar−code readers, pumping of solid state lasers, laser surgery and optical measurement systems which presently use He−Ne lasers.

The following sections relate mainly to optical storage systems employing laser diodes. The require−ments of these laser diodes meet the requirements of laser diodes used in the other applications mentioned above. The semiconductor laser diode used for storing data on high−density optical disks is a key component because the wavelength of the radiation determines to a large extent the achievable storage density. Other requirements for these lasers are higher available optical power, which is limited by COD (Catastrophic Optical Damage) of the device, and improved reliability which is crucial for the overall system reliability. Known storage systems are based on AlGaAs lasers, lasing at a wavelength of 780 nm and reaching power levels of $\leq$ 30 mW. Laser diodes with reduced wavelength, improved optical output power and lifetime are important for future storage systems and the other optoelectronic applications mentioned.

Different technical proposals are known to improve optical storage systems. One important development are devices emitting short wavelength which are based on second harmonic generation in non−linear optical material. The output power and reliability of these devices is not satisfying. The employment of improved AlGaInP/GaInP laser diodes with a wavelength of about 670 nm, increased output power and performance would allow for a 30 percent increase in storage density and an improved reliability of the whole storage system.

The quaternary AlGaInP, lattice matched to GaAs, having a direct bandgap up to 2.3 eV, is presently the most interesting candidate for the above mentioned applications. Owing to advanced growth techniques, it has become possible to utilize the quaternary AlGaInP for diodes emitting in the range between 600 and 700 nm. One advantage of AlGaInP is the complete lattice match to crystalline quality binary GaAs substrate. In fact, almost all AlGaInP diodes reported today have been grown by MOVPE (Metal Organic Vapor Phase Epitaxy).

Several AlGaInP visible light double−heterostructure (DH) lasers have been reported, most of them consisting of an undoped GaInP active layer embedded between a n−doped AlGaInP cladding layer and a p−doped AlGaInP cladding layer. A list of literature relating to these DH lasers is given below:

- "Room−Temperature Pulsed Operation of AlGaInP/GaInP/AlGaInP Double Heterostructure Visible Light Laser Diodes Grown by Metalorganic Chemical Vapor Deposition", I. Hino et al., Appl. Phys. Lett., Vol. 43 (11), December 1983, pp. 987 − 989. In this article a double heterostructure laser diode is reported having an undoped GaInP active layer sandwitched between an n−doped lower AlGaInP cladding layer and a p−doped AlGaInP upper cladding layer, the double heterostructure being grown on top of a GaAs substrate.
- "MOCVD Growth of $(Al_xGa_{x−1})_yIn_{1−y}P$ and Double Heterostructures for Visible Light Lasers", I. Hino, T. Suzuki, Journal of Crystal Growth, Vol. 68, 1984, pp. 483 − 489. I. Hino et al. report a DH structure in this article, consisting of the following stacked layers: GaAs substrate, n−AlGaInP cladding layer, undoped GaInP active layer, and p−AlGaInP cladding layer.
- "Room−Temperature Continuous−Wave Operation of an AlGAInP Mesa Stripe Laser", M. Ikeda et al., Appl. Phys. Lett., Vol. 48 (2), January 1986, pp. 89 − 91. A DH structure consisting of an active GaInP layer embedded between p− and n−doped AlGaInP cladding layers and situated on top of a GaAs substrate is disclosed in this paper.
- "Very Low Threshold Current Density of a GaInP/AlGaInP Double−Heterostructure Laser Grown by MOCVD", K. Nakano et al., Electronics Letters, Vol. 23, No. 17, August 1987, pp. 894 − 895. In this article, the authors report a conventional DH structure GaInP/AlGaInP laser diode grown on top of a GaAs substrate.

- "Transverse – Mode – Stabilized Ridge Stripe AlGaInP Semiconductor Lasers Incorporating a Thin GaAs Etch – Stop Layer", T. Tanaka et al., Appl. Phys. Lett., Vol. 54 (15), April 1989, pp. 1391 – 1393. The laser diode described in this paper has a AlGaInP/GaInP heterostructure situated on top of a GaAs substrate.

- "Semiconductor Laser Device and the Manufacturing Method thereof", European Patent Application EP 0 328 393. This patent application discloses a DH laser diode consisting of AlGaInP/GaInP.

- "Manufacturing Method of Semiconductor Laser with non – absorbing Mirror Structure", European Patent Application EP 0 373 933. Different DH laser diodes are reported in this application consisting of AlGaInP/GaInP.

- "Radiation – emitting Semiconductor Device and Method of Manufacturing such a Semiconductor", European Patent Application EP 0 390 262. An AlGaInP/GaInP DH laser diode with ridge structure is disclosed in this application.

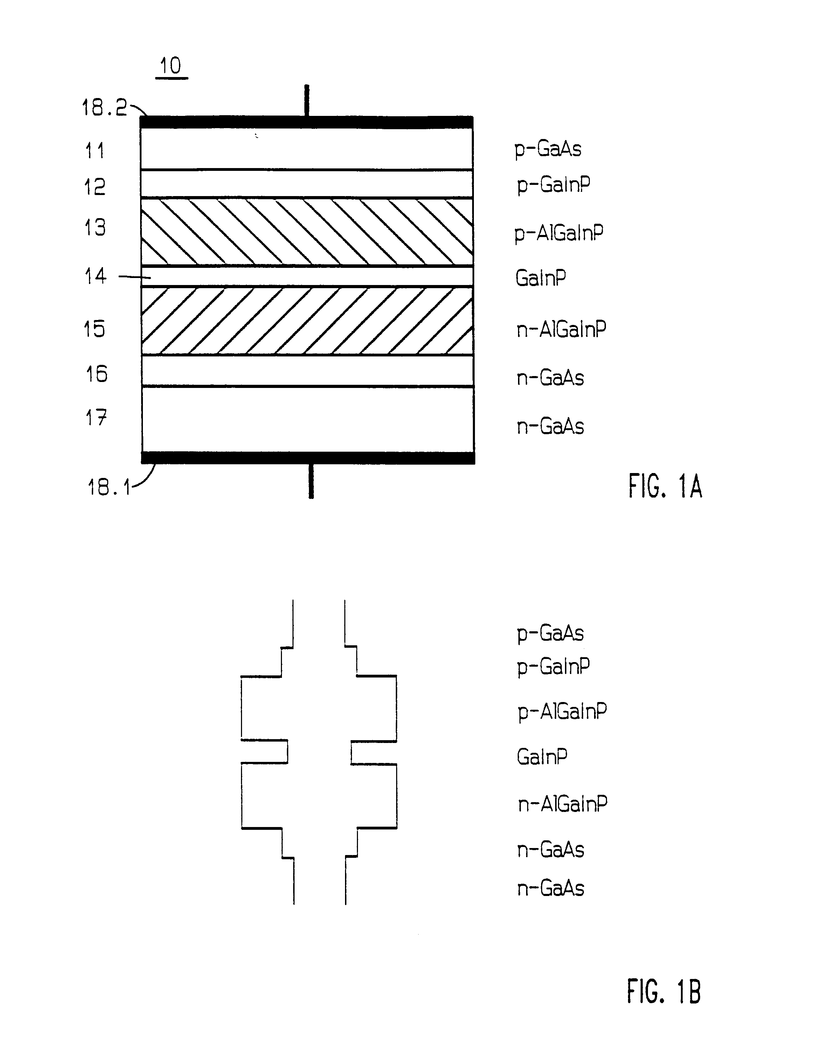

The devices described in the above cited articles and patent applications have a simple double heterostructure. A comparable double heterostructure and its bandgap diagram are shown in Figure 1. The wavelength achieved by these lasers is typically between 670 and 690 nm. Their practical maximum output power up to now is, in lateral single mode narrow devices, less than 30 mW. The AlGaInP system per se is suitable for laser wavelength shorter than 670 nm. Some laser diodes with wavelength of 680 nm and below have been reported as described in the following section.

Analogous to the AlGaAs system, quantum well (QW) lasers can be realized with AlGaInP semicon – ductors. The wavelength of these devices is usually lower than that of comparable DH lasers. Exemplary literature relating to AlGaInP QW laser structures is listed below.

- "Short – Wavelength (625 nm) Room – Temperature Continuous Laser Operation on $In_{0.5}(Al_xGa_{1-x})_{0.5}P$ Quantum Well Heterostructures", D.W. Nam et al., Appl. Phys. Lett., Vol. 52 (16), April 1988, pp. 1329 – 1331. D.W. Nam describes a AlGaInP/GaInP QW laser diode grown on a GaAs substrate.

- "Room – Temperature, Continuous – Wave Operation for Mode – Stabilized AlGaInP Visible – Light Semiconductor Laser with a Multiquantum – Well Active Layer", S. Kawata et al., Electronics Letters, Vol. 24, No. 24, November 1988, pp. 1489 – 1490. A transverse mode stabilized AlGaInP/GaInP multi – quantum well laser diode is reported in this article.

- "High Performance AlGaInP/GaInP MQW GRINSCH Lasers", P. Roentgen et al., 12th IEEE Interna – tional Semiconductor Laser Conference, 9 September 1990, Davos, Post Deadline Papers, PD – 11, pp. 23 – 24. P. Roentgen et al. present na AlGaInP/GaInP multi – quantum well graded index separate confinement heterostructure (GRINSCH) laser in this conference paper.

- "High Quality Index Guided Ridge AlGaInP/GaInP Visible Lasers", G.L. Bona et al., 12th IEEE International Semiconductor Laser Conference, 9 September 1990, Davos, Conference Digest, L – 3, pp. 178 – 179. Ridge lasers with AlGaInP/GaInP DH and MQW structure are disclosed in this paper.

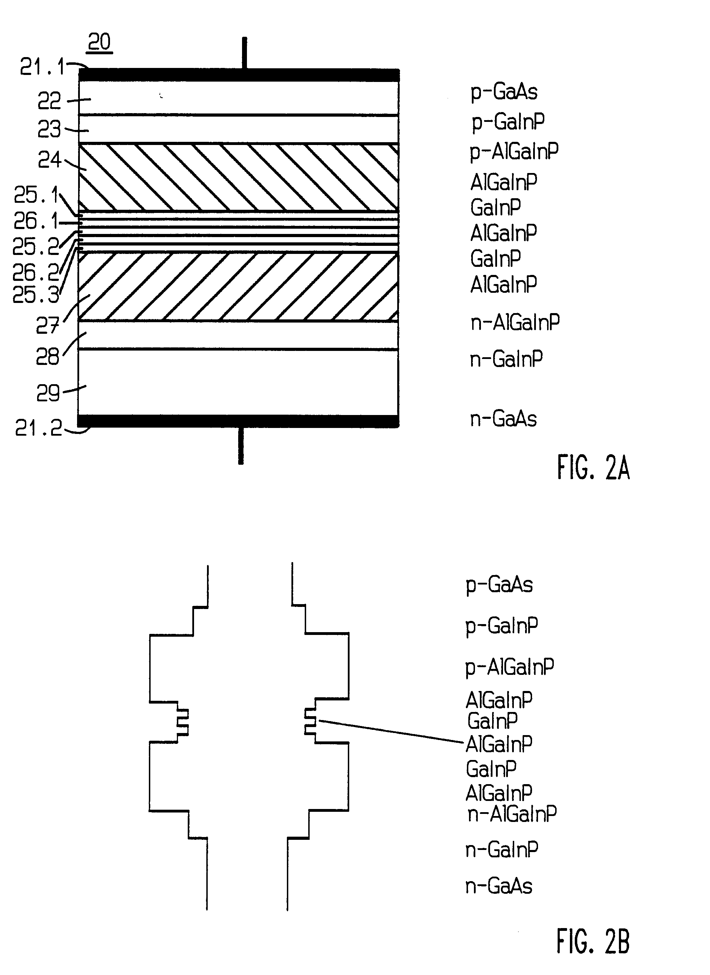

A typical MQW (Multi – Quantum Well) structure, as disclosed in the above cited article of G.L Bona et al. and similar to the MQW structure described in the article of S. Kawata et al., is illustrated in Figure 2A. The corresponding bandgap diagram is shown in Figure 2B. The main improvement of this MQW device is its reduced threshold current ($I_{thr}$) and absorption losses ($\alpha$) resulting in an improved efficiency ($\eta$). However, the maximum output power is furtheron limited by catastrophic optical damage (COD). This MQW structure consists of GaInP quantum wells sandwiched between undoped AlGaInP quantum barrier layers together being embedded between a p – doped AlGaInP cladding layer and a n – doped AlGaInP cladding layer. The wavelength of QW laser diodes in general is smaller than that of comparable DH laser diodes. AlGaInP/GaInP QW and MQW lasers emitting wavelength of 670 nm down to 625 nm have been reported in the literature. The maximum output power, limited by the COD of these devices, is reported to be about 10 – 30 mW, depending of the mode of operation, cooling, and geometry of the respective structure.

To come up with laser diodes lasing between 600 and 700 nm and having an improved maximum output power, additional improvements of these known structures are necessary. As known in the art the output power is limited by catastrophic optical damage (COD). The laser facets seem to play an important role in limiting the maximum output power. The temperature rise caused by lasing light absorption at the facets results into COD and destruction of the devices. Several proposals and structures are known improving the quality of the laser facets, most of them relating to AlGaAs lasers. Four articles disclosing methods and/or structures resulting in AlGaInP/GaInP lasers with increased output power are listed below.

- "Novel Window – Structure AlGaInP Visible LDs with Non – Absorbing Facets Formed by Disordering of Natural Superlattice in GaInP Active Layer", Y. Ueno et al., 12th IEEE International Semiconductor Laser Conference, 9 September 1990, Davos, Conference Digest, C – 2, pp. 30 – 31;

- "Novel Window – Structure AlGaInP Visible – Light Laser Diodes with Non – Absorbing Facets Fab – ricated by Utilizing GaInP Natural Superlattice Disordering", Y. Ueno et al., Jap. Journ. Appl. Phys.,

Vol. 29, No. 9, September 1990, pp. L 1666 − L 1668;
- "Window − Structure InGaAlP Visible Light Laser Diodes by Self − Selective Diffusion Induced Disor −
dering", K. Itaya et al., 12th IEEE International Semiconductor Laser Conference, 9 September 1990,
Davos, Conference Digest, C − 5, pp. 36 − 37;
- "Improvement of Catastrophic Optical Damage Level of AlGaInP Visible Laser Diodes by Sulfur
Treatment", S. Kamiyama et al., Appl. Phys. Lett., Vol. 58 (23), June 1991, pp. 2595 − 2597;

Recently, high − power visible laser diodes of up to 80 mW have been disclosed, having disordered active
layers such that the light is hardly absorbed in a window region at the facets. The fabrication of these types
of structures is complicated and expensive. As described in the article of S. Kamiyama et al., the COD level
of AlGaInP laser diodes can be raised by a Sulfur treatment of the cleaved laser facets. COD levels of about
30 mW have been achieved as described in this article. Comparable windows structures with non −
absorbing facets and treatments of the laser facets were known for AlGaAs laser diodes to be effective for
increasing the maximum output power limited by COD.

SUMMARY OF THE INVENTION

The main object of this invention is to provide a semiconductor diode emitting visible light, which does
not suffer or suffer at least to a considerably lesser extent from the limitations mentioned.
It is another object of this invention to provide a laser structure with improved COD level to increase the
maximum output power.
Another object of the present invention is to provide a diode structure with improved performance.
A further object is to provide a laser structure with reduced threshold current.
It is another object of this invention to provide a laser structure with high differential quantum efficiency.
It is another object of this invention to provide a diode structure with low ohmic resistance.
The invention as claimed is intended to meet these objectives and to remedy the remaining deficiencies
of known AlGaInP or AlGaInAs diodes. The principle by which this is accomplished is to provide for an
active layer being embedded between thin AlGaInP (AlGaInAs) barrier layers and together sandwiched
between thick AlGaAs (InP) cladding layers raising the COD level, reducing the electric resistance, and
improving the differential quantum efficiency.

DESCRIPTION OF THE DRAWINGS AND SHORT FORMS

The invention is described in detail below with reference to the following drawings which are schematic
and not drawn to scale, while more particularly the thickness of cross − sectional shown semiconductor
layers are exaggerated for the sake of clarity.

FIG. 1A is a cross − section through a conventional double − heterostructure AlGaInP/GaInP laser
diode.

FIG. 1B is a bandgap diagram of the layer sequence of the double − heterostructure AlGaInP/GaInP
laser shown in Figure 1A.

FIG. 2A is a cross − section through a typical multi − quantum well AlGaInP/GaInP laser diode.

FIG. 2B is a bandgap diagram of the layer sequence of the multi − quantum well AlGaInP/GaInP laser
shown in Figure 2A.

FIG. 3A is a cross − section through a double − heterostructure AlGaInP/GaInP laser diode with thin
barrier layers and AlGaAs cladding, in accordance with the first embodiment of the present
invention.

FIG. 3B is a bandgap diagram of the layer sequence of the double − heterostructure AlGaInP/GaInP
laser diode shown in Figure 3A.

FIG 4 is a diagram showing the bandgaps, wavelength and refractive indexes of AlGaInP and
AlGaAs as functions of the Aluminum fraction.

FIG. 5 is a diagram showing the $Al_xGa_{1-x}AS$ and $(Al_xGa_{1-x})_yIn_{1-y}P$ composition dependance of the
thermal resistance.

FIG. 6 is a bandgap diagram of a simple separate confinement double − heterostructure layer
sequence embedded between AlGaInP barrier layers and AlGaAs claddings, in accordance
with the second embodiment of the present invention

FIG. 7A is a cross − section through a multi − quantum well AlGaInP/GaInP laser diode with thin
barrier layers and AlGaAs cladding, in accordance with the third embodiment of the present
invention.

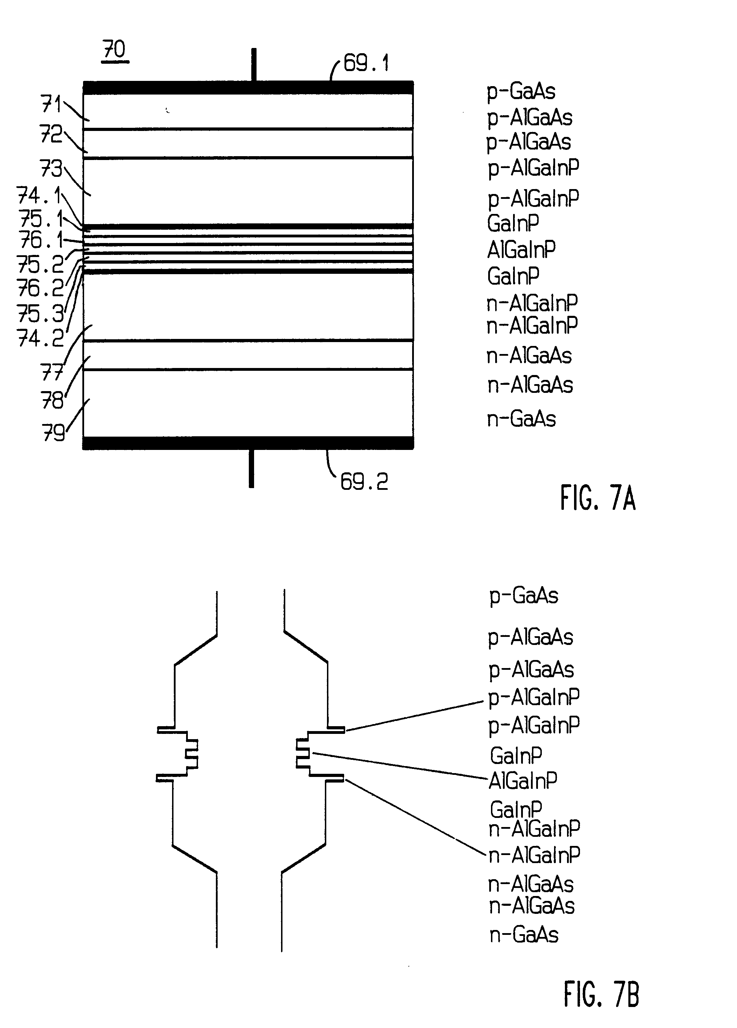

FIG. 7B is a bandgap diagram of the layer sequence of the multi − quantum well AlGaInP/GaInP laser

diode shown in Figure 7A.

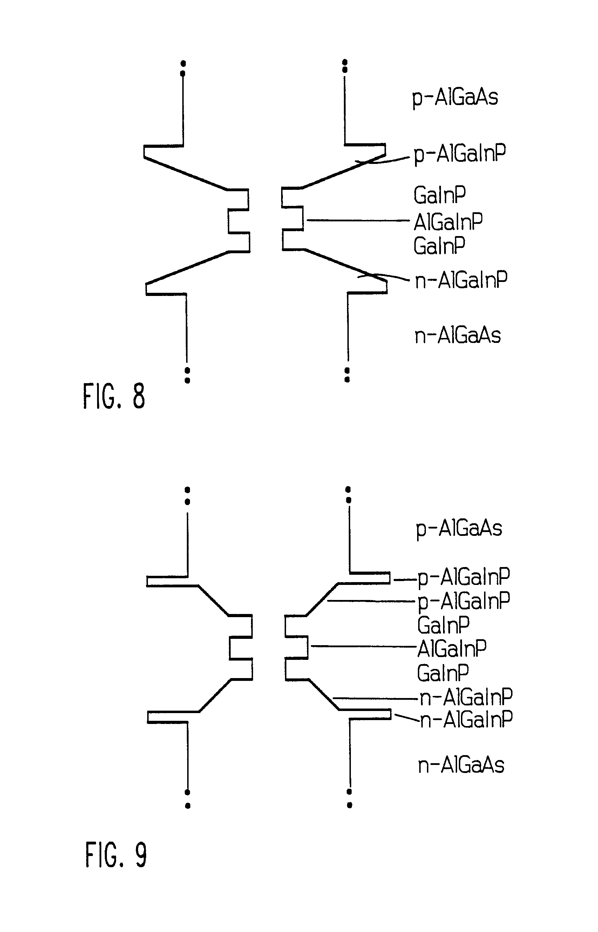

FIG. 8   is a bandgap diagram of a multi − quantum well AlGaInP/GaInP layer sequence embedded between thin AlGaInP barrier layers and AlGaAs claddings.

FIG. 9   is a bandgap diagram of a multi − quantum well AlGaInP/GaInP layer sequence embedded between thin AlGaInP barrier layers and AlGaAs claddings.

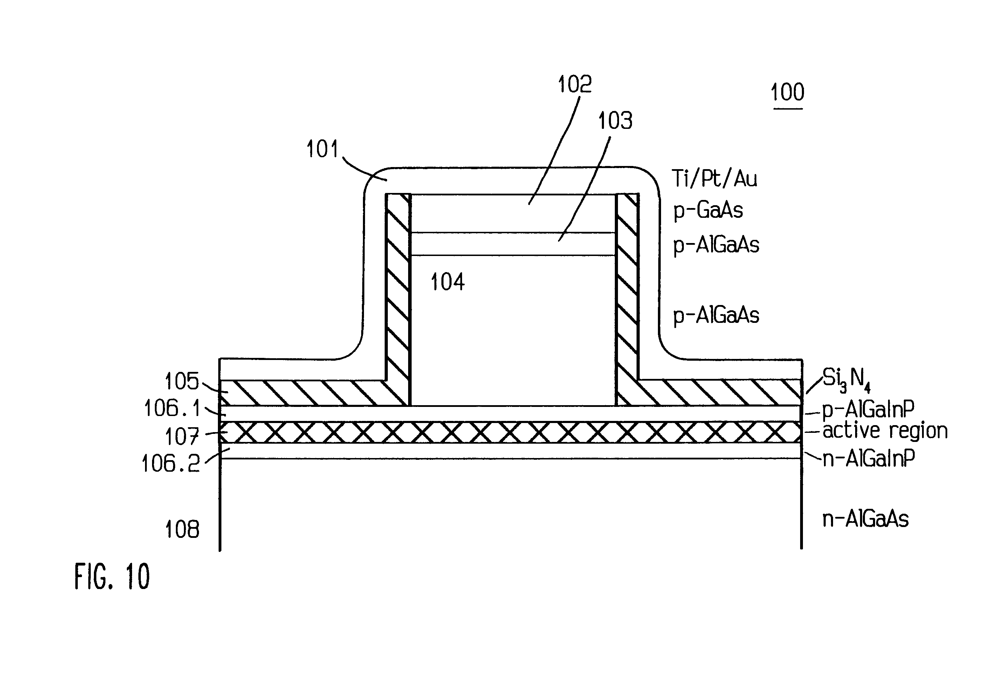

FIG. 10  is a cross − section through a AlGaInP/GaInP ridge laser diode with thin AlGaInP barrier layers and AlGaAs cladding, in accordance with the fourth embodiment of the present invention.

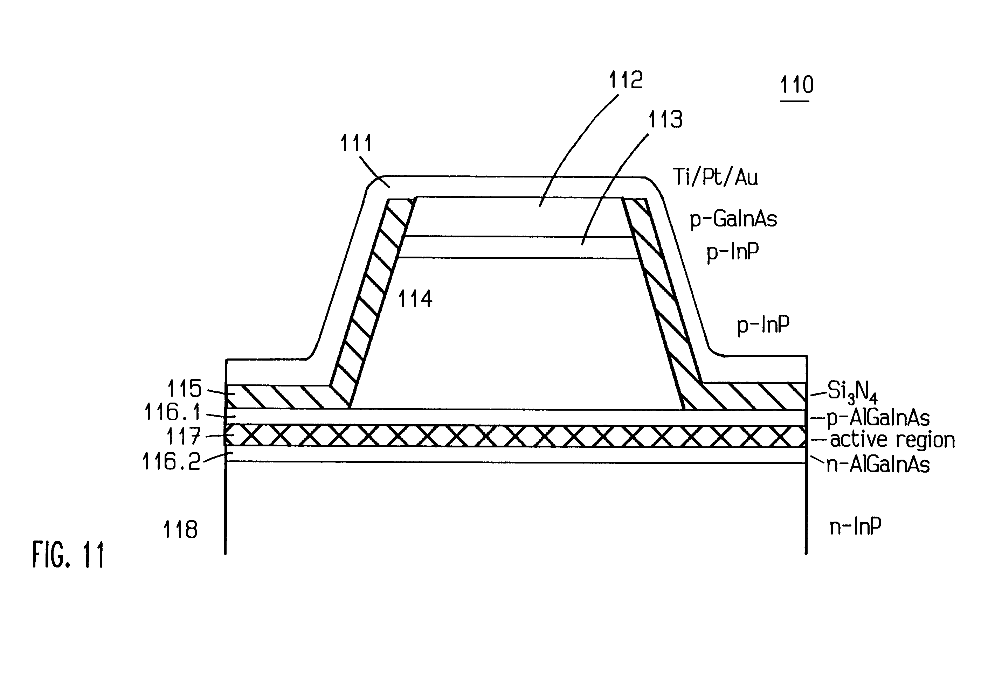

FIG. 11  is a cross − section through a AlGaInAs/GaInAs ridge laser diode with thin AlGaInAs barrier layers and InP cladding, in accordance with the fifth embodiment of the present invention.

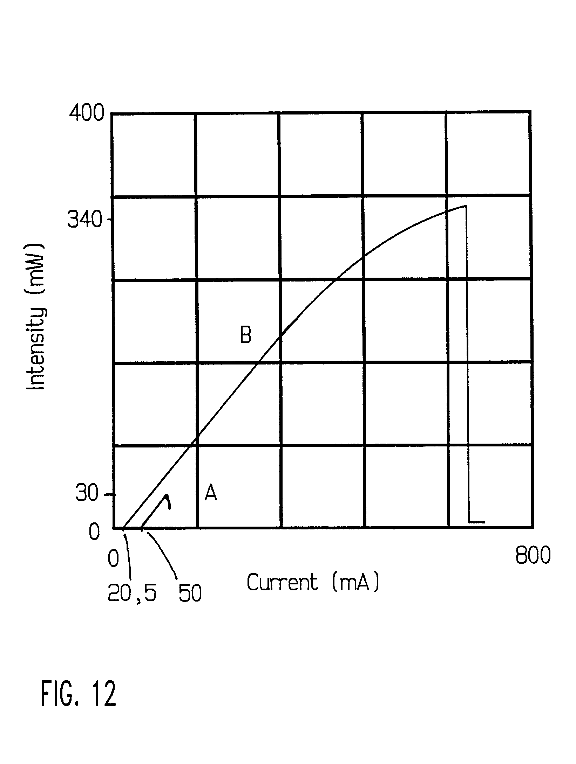

FIG. 12  is an intensity versus current diagram of known MQW laser diode (A) as shown in Figure 2A and a MQW structure (B) with thin barrier layers and AlGaAs cladding, in accordance with the present invention.

| Short forms used in the specification | |
|---|---|
| **Short form** | |
| **AlGaInP** | $(Al_xGa_{1-x})_yIn_{1-y}P$ |
| **GaInP** | $Ga_xIn_{1-x}P$ |
| **AlGaInAs** | $(Al_xGa_{1-x})_yIn_{1-y}As$ |
| **AlGaAs** | $Al_xGa_{1-x}As$ |
| **Al↑GaAs** | $Al_{x_1}Ga_{1-x_1}As => Al_{x_2}Ga_{1-x_2}As$ and $x_1 < x_2$ |
| **Al↓GaAs** | $Al_{x_1}Ga_{1-x_1}As \Leftarrow Al_{x_2}Ga_{1-x_2}As$ and $x_1 < x_2$ |

GENERAL DESCRIPTION

The following description relates mainly to AlGaInP/GaInP quantum well and double − heterostructure loser diodes and LEDs, one embodiment disclosing the inventive structure being transferred into the long wavelength AlGaInAsP/InP system.

A conventional DH loser diode 10, as for example disclosed in the article "Room − Temperature Pulsed Operation of AlGaInP/GaInP/AlGaInP Double Heterostructure Visible Light Laser Diodes Grown by Metalor − ganic Chemical Vapor Deposition", of I. Hino et al., Appl. Phys. Lett., Vol. 43 (11), December 1983, pp. 987 − 989, is illustrated in Figure 1A. Its bandgap diagram is shown in Figure 1B. The shown DH laser 10 consists of a GaInP active layer 14 being sandwiched between n − and p − doped AlGaInP cladding layers 15 and 13, the thickness of the active layer 15 being typically about 0,1 $\mu$m. The cladding layers 13 and 15 which consist of AlGaInP can be p − doped using Selenium (Se) and n − doped using Zinc (Zn). The cladding layers are about 1 $\mu$m thick. The structure is covered on one side by a p − doped GaInP bandgap matching layer 12 and a p − doped GaAs contact layer 11. The n − doped cladding layer 15 is situated on an n − doped bandgap matching layer 16, which consists of GaAs, and an n − doped GaAs substrate 17. Metal contacts 18.1 and 18.2 are situated at both sides of the device 10.

Figure 2A shows a well known separate confinement MQW (Multi − Quantum Well) laser diode 20 being comparable with the DH diode 10 illustrated in Figure 1A. For active region thickness equivalent to the de Broglie wavelength for thermalized electrons, the hole and electron energy levels become quantized in a manner given by the bound state energies of a finite square potential well. This effect is used in the quantum well laser diodes.

The MQW structure 20, schematically shown in Figure 2A, consists of two undoped GaInP quantum wells 26.1, 26.2 embedded between, undoped or slightly doped AlGaInP waveguide layers 25.1 and 25.3. The quantum wells 26.1, 26.2 are separated by an undoped quantum barrier layer 25.1 and the whole quantum well structure is sandwiched between thick p − and n − doped cladding layers 24 and 27 consisting of AlGaInP. These cladding layers 24, 27 are followed by p − and n − doped GaInP bandgap matching layers 23 and 28. A p − doped contact layer 22 with metal contact 21.1 is situated on top of the device and an n − doped contact layer 29 with metal contact 21.2 on the opposite side. The bandgap diagram of the MQW layer sequence of Figure 2A is illustrated in Figure 2B. An example for the thickness of the layers can be given as follows: bandgap matching layers 23 and 28 about 0,1 μm, cladding layers 24 and 27 about 1 μm, waveguide layers 25.1 and 25.3 about 0,2 μm, quantum barrier layer 25.2 about 0,004 μm (4 nm), and quantum wells 0,2 μm. In the article "High Performance AlGaInP/GaInP MQW GRINSCH Lasers", P. Roentgen et al., 12th IEEE International Semiconductor Laser Conference, 9 September 1990, Davos, Post Deadline Papers, PD − 11, pp. 23 − 24, has been shown that these MQW lasers exhibit significant lower threshold currents ($I_{thr}$) and higher efficiencies ($\eta$) in comparison to the DH diodes as for example shown in Figure 1A. In addition, MQW laser diodes emit shorter wavelength than comparable DH lasers.

Some disadvantages of the devices known in the art are the high resistivity of the thick p − AlGaInP cladding layers caused by the low hole mobility of 10 − 20 cm$^2$/Vs and large acceptor binding energy of > 100 meV. The power budget of these lasers is strongly determined by this. Growth of low resistive p − claddings requires incorporation of very high doping levels, running the risk that the pn − junction starts to displace uncontrollably due to diffusion of the dopants.

When growing thick AlGaInP cladding layers by MOVPE on a slightly misoriented GaAs substrate, the formation of large defects is a serious problem. The number and extension of this defects strongly increase with higher Al − content and larger layer thickness. This effect can be somewhat reduced by using stronger misoriented substrates or using extremely high PH$_3$ flows during growth. Although there is no definitive proof, we have clear indications that the defects influence the laser performance, e.g. yield, and reliability of visible AlGaInP lasers.

Additionally to the high ohmic resistance, the high thermal resistance of 17 Kcm/W of the AlGaInP layers forces to mount these lasers junction − down on a good heat sink. Even then, at a case temperature of 20˚C, the junction temperature in cw (continuous wave) operation is typically already > 35˚C at threshold. In order to reduce this value, a thermally improved structure would be desirable.

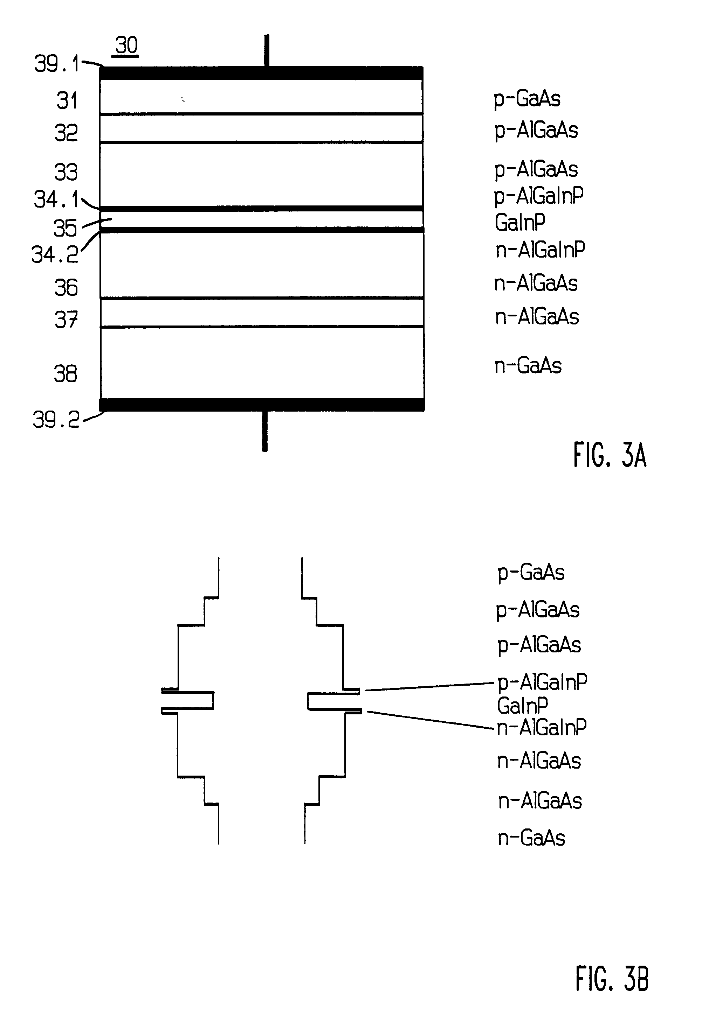

A key point of the invention, as described in connection with the first embodiment illustrated in Figure 3A, is to replace a large fraction of the thick, former AlGaInP cladding layers against AlGaAs cladding layers 33 and 36. Very thin AlGaInP barrier layers 34.1, 34.2 are situated between these AlGaAs cladding layers 33, 36 and the active layer 35. As seen in Figures 3A and 3B, the active recombination region, i.e. the active layer 35, remains unchanged, whereas the thickness of the former high Al − mole fraction AlGaInP cladding layers 34.1, 34.2 is reduced to a minimum, just avoiding tunneling and spill over of carriers from the active region into the AlGaAs cladding 33, 36. The thickness $t_b$ of the thin AlGaInP barrier layers 34.1, 34.2 can be much smaller than the wavelength λ of the laser ($t_b \ll \lambda$) such that these barrier layers 34.1 and 34.2 are not optically active. The quantum mechanical transmission probability $T_t$, hereinafter referred to as tunneling probability, can be described by the following equation:

$$T_t = \left[ 1 + \frac{E_0^2 \sinh^2 \kappa W}{4E(E_0 - E)} \right]^{-1} \tag{1}$$

with

$$\kappa = \sqrt{\frac{2m^*(E_0 - E)}{\hbar^2}} \tag{2}$$

where W is the thickness of the energy barrier, $E_0$ is the height of this barrier, E is the energy of the carrier and m* their effective mass. When $\hbar W \gg 1$, the tunneling probability becomes

$$T_t = \frac{16E(E_0 - E)}{E_0^2} \exp(-2\kappa W). \tag{3}$$

The thickness of the barrier strongly effects the tunneling probability as can be seen from equation (3), which is mainly a problem of electrons ($e^-$) because of their small m*. To prevent tunneling of e through the barrier layers 34.1 and 34.2, barrier thickness of at least 0,01 $\mu$m (10 nm) are required. To prevent holes (h) from tunneling through a barrier, the barrier thickness can be smaller according to the larger effective mass (m*) of the holes. Good results can be achieved using quantum barrier layers with a thickness of about 0,0057 $\mu$m (5,7 nm) as reported in the article "Design and Photoluminescence Study on a Multiquantum Barrier", of T. Takagi et al., IEEE Journ. of Quantum Electronics, Vol. 27, No. 6, June 1991, pp. 1511 − 1517. Thin barrier layers can be grown lattice matched and strongly relaxed having a bandgap about 2,2 eV. Intentionally strained thin barrier layers could replace these relaxed layers thus allowing a modification of the barrier properties. e.g increasing their bandgap to be > 2,2 eV.

By the employment of disordered barrier layers instead of ordered layers a further possibility is given to modify the properties of the barriers. As disclosed in the article "Evidence for the Existence of an Ordered State in $Ga_{0.5}In_{0.5}P$ grown by Metalorganic Vapor Phase Epitaxy and its Relation to Band − gap Energy", of A. Gomyo et al., Appl. Phys. Lett., 50 (11), March 1987, pp. 673 − 675, the bandgap energy of metalorganic vapor phase epitaxially (MOVPE) grown $Ga_{0.5}In_{0.5}P$ is a function of a wide range of V/III ratios and growth temperatures. By growing the barrier layers such that the Ga − In − distribution on the column III element sublattice is different from the ordered, regularly arranged, Ga − In − distribution, the bandgap can be modified.

The inventive laser diode 30, schematically shown in Figure 3A, consists of a double heterostructure with GaInP active layer 35 embedded between a p − doped upper AlGaInP barrier layer 34.1 and an n − doped lower AlGaInP barrier layer 34.2. The thickness of these barrier layers 34.1 and 34.2 should preferably be between 0,01 and 0,1 $\mu$m. This layer sequence 34.1, 35, 34.2 is sandwiched between thick AlGaAs cladding layers 33, 36, the upper cladding layer 33 being p − doped and the lower cladding layer 36 being n − doped. Doped AlGaAs bandgap adaptation layers 32 and 37 are situated on these AlGaAs cladding layers 33 and 36 as bandgap adaptation to the outer contact layer 31 which consists of p − doped GaAs on one side and the n − doped GaAs substrate 38 on the other side. Broad metal contacts 39.1 and 39.2 are deposited on the top and bottom of the device 30.

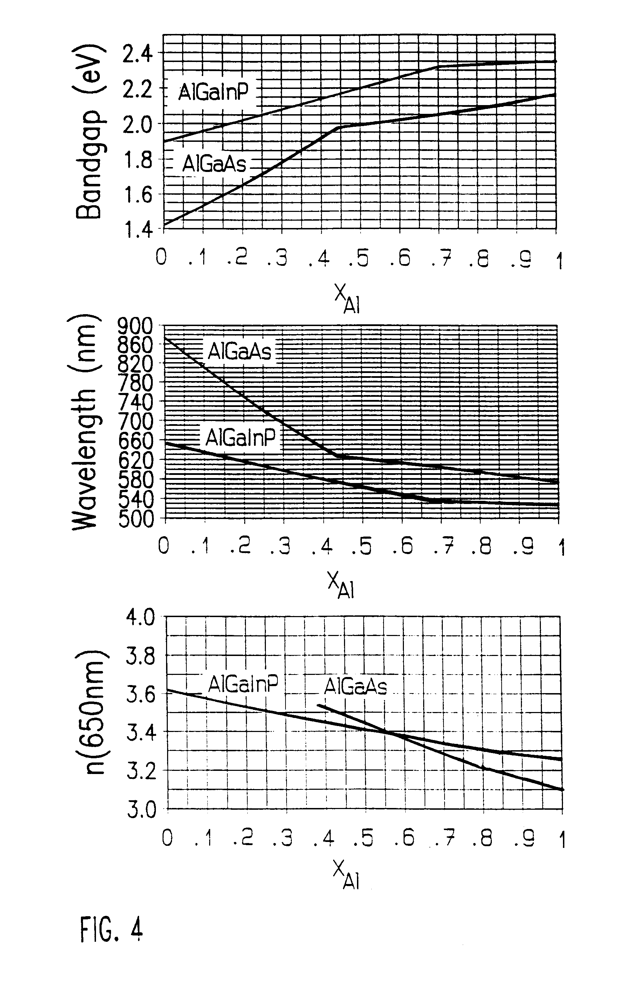

The Al − mole fraction at the contact and substrate side can be simply graded to zero, as for example shown in Figure 7B, which in addition helps to eliminate parasitic barriers. As shown in Figure 4, the Al ($X_{Al}$) fraction in the AlGaAs cladding layers has to be larger than 0,45 to prevent absorption of the laser light and to guide the wave efficiently. The upper diagram of Figure 4 shows the bandgaps of AlGaInP and AlGaAs as functions of the Al fraction ($X_{Al}$), the middle diagram shows the wavelength in dependance of the Al fraction ($X_{Al}$), and the lower diagram shows the refractive indices of AlGaInP and AlGaAs as functions of the Al fraction ($X_{Al}$). The refractive indices of AlGaInP are reported in the article "Refractive Indices of $In_{0.49}Ga_{0.51-x}Al_xP$ Lattice Matched to GaAs", H. Tanaka et al., Journ. Appl. Phys., Vol. 59, No. 3. February 1986, pp. 985 − 986.

Exemplary details of the structure shown in Figure 3 are given in Table 1.

Table 1

| Exemplary details of the first embodiment | | | | | | |
|---|---|---|---|---|---|---|
| Layer | No. | Material | Dopant | Doping Conc. [cm$^{-3}$] | Thickness [$\mu$m] | |
| p − side contact | 39.1 | Ti/Pt/Au | − | − | 0,3 | − |
| contact layer | 31 | p − GaAs | Zn | p = 2 × 10$^{19}$ | 0,1 | − |
| bandgap adapt. layer | 32 | p − AlGaAs | Zn | p = 2 × 10$^{18}$ | 0,1 | x = 0,35 |
| cladding layer | 33 | p − AlGaAs | Zn | p = 1 × 10$^{18}$ | 1,5 | x = 0,7 |
| barrier layer | 34.1 | p − AlGaInP | Zn | p = 5 × 10$^{17}$ | 0,05 | x = 0,7 |
| | | | | | | y = 0,5 |
| active layer | 35 | GaInP | none | − | 0,08 | x = 0,5 |
| barrier layer | 34.2 | n − AlGaInP | Si | n = 5 × 10$^{17}$ | 0,05 | x = 0,7 |
| | | | | | | y = 0,5 |
| cladding layer | 36 | n − AlGaAs | Si | n = 1 × 10$^{18}$ | 1,5 | x = 0,5 |
| bandgap adapt. layer | 37 | n − AlGaAs | Si | n = 1 × 10$^{18}$ | 0,1 | x = 0,35 |
| substrate | 38 | n − GaAs | Si | n = 2 × 10$^{18}$ | 350 | − |
| n − side contact | 39.2 | AuGe/Ni/Au | − | − | 0,3 | − |

Figure 3 shows a simple structure of a broad contact laser diode 30 with contact size 50 X 1000$\mu$m$^2$. This first embodiment can be simply modified by increasing or decreasing the thickness of the layers, inserting an unstrained MQW active structure or a strained MQW active structure replacing the active layer 35 described above. In addition the inventive structure can be used in a ridge waveguide laser diode or a mesa stripe laser diode instead of the broad contact laser diode described above. Graded buffer layers can be employed as known in the art, replacing the bandgap adaptation layers.

All embodiments herein described are grown on n − doped substrates to simplify the description and drawings. All shown devices can be modified starting with a p − doped substrate and successively growing the respective layers, reversely doped, thereon.

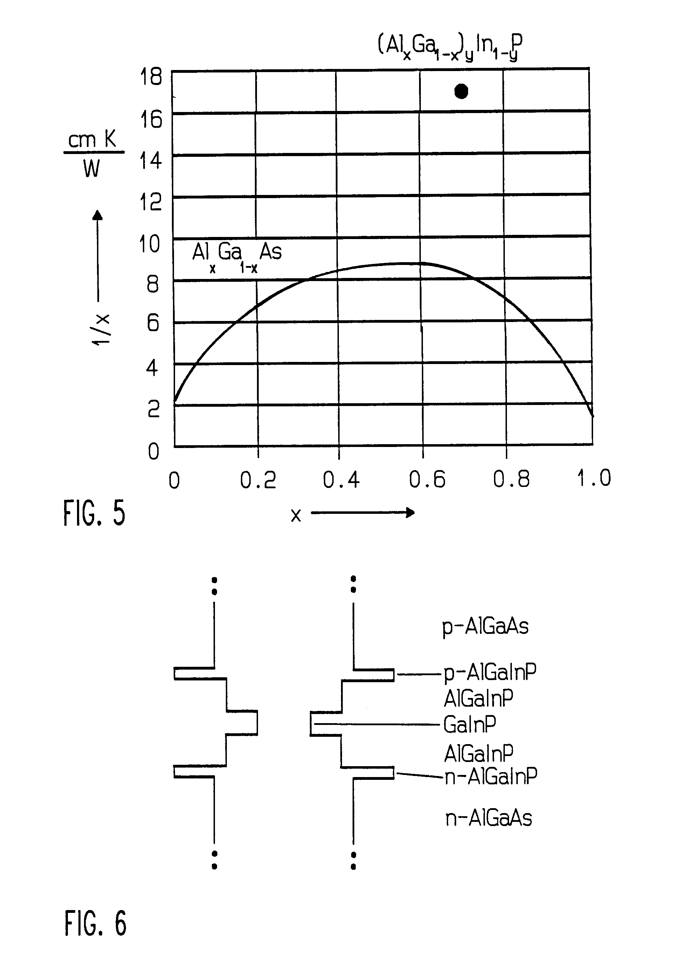

The second embodiment is a AlGaInP/GaInP separate confinement double heterostructure laser diode. A sketch of the corresponding bandgap diagram is shown in Figure 6. The undoped GaInP active layer of this embodiment is embedded between two undoped or slightly doped AlGaInP confinement layers. This active region is sandwiched between thin p − or n − doped AlGaInP barrier layers and thick p − or n − doped AlGaAs claddings, as illustrated in the bandgap diagram of Figure 6.

The third embodiment based on the inventive structures as shown in Figures 3A, 3B, and 6 is illustrated in Figure 7, which shows a schematic cross − section of a multi − quantum well structure and its bandgap diagram. This third embodiment is a MQW laser diode 70 its active region consisting of undoped GaInP active layers 76.1 and 76.2 (quantum wells) separated by a quantum barrier 75.2 and embedded between waveguide layers 75.1 and 75.3, these layers consisting of undoped or slightly p − and n − doped AlGaInP. This active region is embedded between an upper p − doped AlGaInP barrier layer 74.1 and a lower n − doped AlGaInP barrier layer 74.2. The outer layer sequences on both sides of the device is comparable to the sequence described before. The only difference is that the bandgap adaptation layers, layers 72 and 78 of the third embodiment, are graded bandgap layers as shown in Figure 7B. By employment of these graded bandgap layers 72, 78 it is possible to adapt the bandgap of the doped − AlGaAs claddings 73 and 77 to the contact layer 71 on one side and the substrate 79 on the other side. Exemplary details of the third embodiment are given in Table 2.

Table 2

| Exemplary details of the third embodiment | | | | | | |
|---|---|---|---|---|---|---|
| Layer | No. | Material | Dopant | Doping Conc. [cm$^{-3}$] | Thickness [$\mu$m] | |
| p $-$ side contact | 69.1 | Ti/Pt/Au | $-$ | $-$ | 0,25 | $-$ |
| contact layer | 71 | p $-$ GaAs | Zn | $p > 2 \times 10^{19}$ | 0,1 | $-$ |
| graded band $-$ gap layer | 72 | p $-$ Al$\downarrow$GaAs | Zn | $p = 2 \times 10^{18}$ | 0,1 | $0,1 \leqq x \leqq 0,7$ |
| cladding layer | 73 | p $-$ AlGaAs | Zn | $p = 1 \times 10^{18}$ | 1,5 | $x = 0,7$ |
| barrier layer | 74.1 | p $-$ AlGaInP | Zn | $p = 5 \times 10^{17}$ | 0,05 | $x = 0,7$ $y = 0,5$ |
| waveguide layer | 75.1 | p $-$ AlGaInP | Zn | $p = 2 \times 10^{17}$ | 0,2 | $x = 0,7$ $y = 0,5$ |
| quantum well | 76.1 | GaInP | none | $-$ | 0,01 | $x = 0,5$ |
| quantum barrier | 75.2 | AlGaInP | none | $-$ | 0,004 | $x = 0,7$ $y = 0,5$ |
| quantum well | 76.2 | GaInP | none | $-$ | 0,01 | $x = 0,7$ |
| waveguide layer | 75.3 | n $-$ AlGaInP | Si | $n = 2 \times 10^{17}$ | 0,2 | $x = 0,7$ $y = 0,5$ |
| barrier layer | 74.2 | n $-$ AlGaInP | Si | $n = 5 \times 10^{17}$ | 0,05 | $x = 0,7$ $y = 0,5$ |
| cladding layer | 77 | n $-$ AlGaAs | Si | $n = 1 \times 10^{18}$ | 1,5 | $x = 0,7$ |
| graded band $-$ gap layer | 78 | n $-$ Al$\uparrow$GaAs | Si | $n = 2 \times 10^{18}$ | 0,1 | $0,7 \geqq x \geqq 0,1$ |
| substrate | 79 | n $-$ GaAs | Si | $n = 2 \times 10^{18}$ | 350 | $-$ |
| n $-$ side contact | 69.2 | AuGe/Ni/Au | $-$ | $-$ | 0,25 | $-$ |

This embodiment can be easily modified e.g. by replacing the shown active region 75.1 $-$ 75.3, 76.1 and 76.2 against other multi $-$ quantum well structures. Further modifications are illustrated in Figures 8 and 9. In both figures barrier layers with graded bandgaps are shown embedding the quantum well structure. A parabolic grading of optical confinement layers would be a further modification.

A fourth embodiment is illustrated in Figure 10 which shows a cross $-$ sectional view of an AlGaInP/GaInP laser diode 100 with ridge structure. The active region 107, shown as cross $-$ hatched layer may consist of a double heterostructure or (multi $-$) quantum well structure as described before. This active region 107 is embedded between a thin upper p $-$ doped AlGaInP barrier layer 106.1 and a thin lower n $-$ doped AlGaInP barrier layer 106.2. The p $-$ AlGaAs cladding 104 on top of the upper barrier layer 106.1 forms a ridge, exemplary shown having vertical sidewalls. A p $-$ doped AlGaAs graded bandgap layer 103 and a p $-$ doped GaAs contact layer are deposited on top of this cladding 104. The sidewalls of the ridge and the thin AlGaInP barrier are covered by a Si$_3$N$_4$ insulating layer 105 and the whole structure is covered by a p $-$ metal contact 101 which provides for an electrical contact to the contact layer 102. The whole layer sequence described above is situated on a substrate (not shown) carrying an n $-$ doped AlGaAs cladding 108. The ridge structure is formed by etching, e.g dry $-$ etching (RIE), the p $-$ AlGaAs cladding layer 104. This etch process automatically stops at the thin barrier layer 106.1 which is another advantage of the inventive structure with thin barrier layers. The thickness of the barrier layers 106.1 and 106.2 may be 0,05 $\mu$m and the thickness h of the ridge p $-$ AlGaAs layer 104 about 2 $\mu$m. The ridge's width may be 5 $\mu$m and its length 500 $\mu$m. Exemplary details of the fourth embodiment are given in the following Table 3.

Table 3

| Exemplary details of the fourth embodiment | | | | | | |
|---|---|---|---|---|---|---|
| Layer | No. | Material | Dopant | Doping Conc. $[cm^{-3}]$ | Thickness $[\mu m]$ | |
| p – side contact | 101 | Ti/Pt/Au | – | – | 0,3 | – |
| contact layer | 102 | p – GaAs | Zn | $p = 2 \times 10^{19}$ | 0,1 | – |
| insul. layer | 105 | $Si_3N_4$ | – | – | 0,2 | – |
| graded band – gap layer | 103 | p – Al↓GaAs | Zn | $p = 2 \times 10^{18}$ | 0,1 | $0,1 \leq x \leq 0,7$ |
| cladding layer | 104 | p – AlGaAs | Zn | $p = 1 \times 10^{18}$ | 1,5 | $x = 0,7$ |
| barrier layer | 106.1 | p – AlGaInP | Zn | $p = 5 \times 10^{17}$ | 0,05 | $x = 0,7$ $y = 0,5$ |
| active region | 107 | – | – | – | – | – |
| barrier layer | 106.2 | n – AlGaInP | Si | $n = 5 \times 10^{17}$ | 0,05 | $x = 0,7$ $y = 0,5$ |
| cladding layer | 108 | n – AlGaAs | Si | $n = 1 \times 10^{18}$ | 1,5 | $x = 0,7$ |
| graded band – gap layer | – | n – Al↑GaAs | Si | $n = 1 \times 10^{18}$ | 0,1 | $0,7 \geq x \geq 0,1$ |
| substrate | – | n – GaAs | Si | $n = 2 \times 10^{18}$ | 350 | – |
| n – side contact | – | AuGe/Ni/Au | – | – | 0,3 | – |

A fifth embodiment is shown in Figure 11. In this figure a longer wavelength AlGaInAs/GaInAs/InP laser diode 110 with ridge structure is illustrated. This structure is comparable to the one shown in Figure 10 but having thin AlGaInAs barrier layers 116.1 and 116.2 instead of AlGaInP barrier layers. The active layer 117 consists of (Al)GaInAs or GaInAsP and the cladding layers 114 and 118 consist of doped InP. This structure is grown on an InP substrate (not shown), the inclined surface of the ridge and the upper surface of the barrier layer 116.1 being covered by a $Si_3N_4$ insulating layer 115. A graded bandgap layer 113, a GaInAs contact layer 112 and a Ti/Pt/Au contact 111 provides for the upper contact of the laser diode 110.

The advantages, we observed in applying our invention to the different embodiments described are listed in the following:

- the defects generated during MOVPE of conventional structures, as illustrated in Figures 1A and 2A, are drastically reduced by replacing the thick AlGaInP (AlGaInAs) cladding layers against AlGaAs (InP) even for Al concentrations in AlGaAs as high as 90 %;
- lattice matching of the AlGaInP (AlGaInAs) layers is strongly relaxed since the layer thickness are in general smaller than the critical layer thickness;
- by intentionally growing strained, compressive or tensile, barrier layers it is possible to modify the barrier, e.g increasing the barrier height;
- by variation of the MOVPE growth temperature during deposition of the barrier layers, it is possible to grow disordered AlGaInP barriers having different properties, e.g another bandgap, than ordered AlGaInP barriers.
- when growing AlGaAs layers with high Al mole fraction by MOVPE, p – doping can be simply accomplished by C – doping adjusting suitable V/III ratios, an effect which has not been found yet in AlGaInP. The C is known to be a slow diffusor and additionally the solubility limit of C in AlGaAs is much higher than that of Zn or other acceptors in AlGaInP thus allowing to enhance substantially the p – doping level;
- the acceptor binding energy in AlGaAs for Al is much smaller in comparison to the one of Zn in AlGaInP, e.g. 40 – 60 meV binding energy for Al mole fractions > 60 % in comparison to the > 100 meV for Zn in AlGaInP;
- the Hall mobility in doped AlGaAs is much higher than that in AlGaInP, e.g. 50 – 80cm²/Vs in p – doped AlGaAs in comparison to 10 – 20cm²/Vs in AlGaInP;
- the last three points allow to reduce the resistivity of the cladding by a factor up to 100 ($\sigma = n$ e $\mu$);

- the thermal resistance of the AlGaAs cladding layer is, depending on the Al mole fraction, between 2 and 8 times smaller than that of AlGaInP having a thermal resistance of about 17Kcm/W. The thermal resistance of AlGaInP is reported in the article "Thermal Behavior of Visible AlGaInP/GaInP Ridge Laser Diodes", O.J.F. Martin et al., IEEE Journ. Quantum Electronics, submitted 1/1991. By employ – ment of the inventive structure with thick AlGaAs cladding layers and only very thin barrier layers consisting of AlGaInP a substantial reduction in the thermal resistance of the visible AlGaInP lasers can be achieved;

- formation of the ridge of ridge waveguide laser diodes either by wet chemical or dry by dry etching is greatly facilitated since easily conditions can be selected where the etching stops automatically on the AlGaInP barrier layer, hence offering ultimate ridge etch depth control. The employment of etch stop layers is known in the art. In the article "Room – Temperature, Continuous – Wave Operation for Mode – Stabilized AlGaInP Visible – Light Semiconductor Laser with a Multiquantum – Well Active Layer", S. Kawata et al., Electronics Letters, Vol. 24, No. 24, November 1988, pp. 1489 – 1490, for example, a QW structure with p – AlGaInP etch stop layer is disclosed.

- Up to now one had to make a trade – off by choosing the thickness of conventional AlGaInP cladding layers. On one hand AlGaInP has a very high thermal resistance such that thermally optimized diodes require thin claddings and on the other hand diodes with thin claddings have a high astigmatism thus reducing the optical beam quality of the device. An important advantage of the present invention is that the low thermal resistance of AlGaAs allows to employ thicker claddings of this material such that the astigmatism and thermal resistance is lower than in conventional devices.

To show the advantages of the invention and their influence on the COD level of inventive laser diodes, the intensity – current curve of a conventional AlGaInP/GaInP laser diode, as described in context with Figure 2, and an intensity – current curve of a diode according to the invention are illustrated in Figure 12. The conventional AlGaInP/GaInP laser diode, its curve being marked with letter 'A', has a threshold current of about 50 mA and a COD level of typically 30 mW. The results of the inventive MQW laser diode (curve 'B') with $5 \times 500\mu m^2$ ridge, described as one of the embodiments, has a threshold current of about 20,5 mA and a COD level about 340 mW. This COD level is about ten times as high as COD levels of known laser diodes. Both lasers were mounted junction side – up during the measurements and had uncoated mirrors.

## Claims

1. Semiconductor diode (30; 70; 100; 110) emitting visible light, comprising an active recombination region (35; 75.1 – 75.3, 76.1, 76.2; 107; 117) embedded between an upper cladding layer (33; 73; 104; 114) and a lower cladding layer (36; 77; 108; 118) characterized in that a thin barrier layer (34.1, 34.2; 74.1, 74.2; 106.1, 106.2; 116.1, 116.2) is situated, at least on one side, between said active recombination region (35; 75.1 – 75.3, 76.1, 76.2; 107; 117) and one of said cladding layers (33, 36; 73, 77; 104, 108; 114, 118), the thickness of said barrier layer (34.1, 34.2; 74.1, 74.2; 106.1, 106.2; 116.1, 116.2) being chosen to avoid tunneling and spill over of carriers from said active recombination region (35; 75.1 – 75.3, 76.1, 76.2; 107; 117) into said cladding layer (33, 36; 73, 77; 104, 108; 114, 118).

2. Semiconductor diode (30; 70; 100; 110) of claim 1, characterized in that said diode (30; 70; 100; 110) comprises AlGaInP/GaInP or AlGaInAs/GaInAs, and that said barrier layers (34.1, 34.2; 74.1, 74.2; 106.1, 106.2; 116.1, 116.2) comprise AlGaInP or AlGaInAsP.

3. Semiconductor diode (30; 70; 100; 110) of claims 1 or 2, characterized in that said active recombination region (35; 75.1 – 75.3, 76.1, 76.2; 107; 117) has a quantum well structure.

4. Semiconductor diode (70; 100; 110) of claims 1 or 2, characterized in that said active recombination region (75.1 – 75.3, 76.1, 76.2; 107; 117) has a multi – quantum well structure.

5. Semiconductor diode (30; 100; 110) of claims 1 or 2, characterized in that said active recombination region (35; 107; 117) has a double heterostructure.

6. Semiconductor diode (30; 70; 100; 110) of any of the preceding claims, characterized in that said cladding layers (33, 36; 73, 77; 104, 108; 114, 118) comprise AlGaAs or InP.

7. Semiconductor diode of any of the preceding claims, characterized in that said active recombination region comprises strained and/or unstrained layers.

8. Double heterostructure semiconductor diode (30) of claim 5, characterized in that it comprises the following stacked layers, ordered by their sequence:
   - n – doped AlGaAs cladding layer (36);
   - n – doped thin AlGaInP barrier layer (34.2);
   - undoped GaInP active layer (35);
   - p – doped thin AlGaInP barrier layer (34.1);
   - p – doped AlGaAs cladding layer (33);
   said cladding layers (33, 36) being substantially thicker than said barrier layers (34.1, 34.2) such that said cladding layers (33, 36) provide for formation of an optical light waveguide.

9. Double heterostructure semiconductor diode of claim 5, characterized in that it comprises the following stacked layers, ordered by their sequence:
   - p – doped AlGaAs cladding layer;
   - p – doped thin AlGaInP barrier layer;
   - undoped GaInP active layer;
   - n – doped thin AlGaInP barrier layer;
   - n – doped AlGaAs cladding layer;
   said cladding layers being substantially thicker than said barrier layers such that said cladding layers provide for formation of an optical light waveguide.

10. Multi – quantum well semiconductor diode (70) of claim 4, characterized in that it comprises the following stacked layers, ordered by their sequence:
   - n – doped AlGaAs cladding layer (77);
   - n – doped thin AlGaInP barrier layer (74.2);
   - slightly n – doped or undoped AlGaInP waveguide layer (75.3);
   - undoped GaInP active layer (76.2);
   - undoped AlGaInP quantum barrier layer (75.2);
   - undoped GaInP active layer (76.1);
   - slightly p – doped or undoped AlGaInP waveguide layer (75.1);
   - p – doped thin AlGaInP barrier layer (74.1);
   - p – doped AlGaAs cladding layer (73),
   said cladding layers (73, 77) being substantially thicker than said barrier layers (74.1, 74.2) such that said cladding layers (73, 77) provide for formation of an optical light waveguide.

11. Multi – quantum well semiconductor diode of claim 4, characterized in that it comprises the following stacked layers, ordered by their sequence:
   - p – doped AlGaAs cladding layer;
   - p – doped thin AlGaInP barrier layer;
   - slightly p – doped or undoped AlGaInP waveguide layer;
   - undoped GaInP active layer;
   - undoped AlGaInP quantum barrier layer;
   - undoped GaInP active layer;
   - slightly n – doped or undoped AlGaInP waveguide layer;
   - n – doped thin AlGaInP barrier layer;
   - n – doped AlGaAs cladding layer,
   said cladding layers being substantially thicker than said barrier layers such that said cladding layers provide for formation of an optical light waveguide.

12. Semiconductor diode (30; 70; 100; 110) of claims 1 or 2, characterized in that said barrier layers (34.1, 34.2; 74.1, 74.2; 106.1, 106.2; 116.1, 116.2) have a thickness between 1 nm – 200 nm.

13. Semiconductor diode of claims 1 or 2, characterized in that said barrier layers have a graded bandgap.

14. Semiconductor diode of claims 1 or 2, characterized in that at least one of said barrier layers is a strained layer.

15. Semiconductor diode of claims 1 or 2, characterized in that at least one of said barrier layers is a disordered layer, the Ga and in atoms being randomly distributed on the sublattice.

16. Semiconductor diode of any of the preceding claims, characterized in that said semiconductor diode is a laser diode.

17. Semiconductor diode of any of the claims 1 − 14, characterized in that said semiconductor diode is a light emitting diode (LED).

**Amended Claims in accordance with Rule 86(2) EPC.**

1. Semiconductor diode (30; 70; 100: 110) emitting visible light, comprising an active recombination region (35; 75.1 − 75.3. 76.1, 76.2; 107; 117) embedded between an upper cladding layer (33; 73; 104: 114) and a lower cladding layer (36; 77; 108; 118), at least one thin barrier layer (34.1, 34.2; 74.1, 74.2; 106.1, 106.2; 116.1, 116.2) being situated between said active recombination region (35; 75.1 − 75.3, 76.1, 76.2; 107; 117) and either said upper cladding layer (33; 73; 104; 114) or said lower cladding layer (36; 77; 108; 118), said active recombination region (35; 75.1 − 75.3, 76.1, 76.2: 107; 117) comprising GaInP or GaInAs, and said thin barrier layer (34.1, 34.2: 74.1, 74.2; 106.1, 106.2; 116.1, 116.2) comprising AlGaIn, the thickness of said barrier layer (34.1, 34.2; 74.1, 74.2; 106.1, 106.2; 116.1, 116.2) being chosen to avoid tunneling and spillover of carriers from said active recombination region (35; 75.1 − 75.3, 76.1, 76.2; 107; 117) into the cladding layer (33, 36; 73, 77; 104, 108; 114, 118) which is separated from the active recombination region (35; 75.1 − 75.3, 76.1, 76.2; 107; 117) by said barrier layer (34.1, 34.2; 74.1, 74.2; 106.1, 106.2; 116.1, 116.2).

2. Semiconductor diode (30; 70; 100; 110) of claim 1, characterized in that said cladding layer (33, 36; 73, 77; 104, 108; 114. 118) comprises either AlGaAs or InP.

3. Semiconductor diode (30; 70; 100; 110) of claim 1, characterized in that said barrier layer (34.1, 34.2; 74.1, 74.2; 106.1, 106.2: 116.1, 116.2) comprises either AlGaInP or AlGaInAs.

4. Semiconductor diode of any of the preceding claims, characterized in that said active recombination region comprises strained and/or unstrained layers.

5. Semiconductor diode (30) of claims 1, 2 or 3, characterized in that it comprises the following stacked layers, ordered by their sequence:
   − n − doped AlGaAs cladding layer (36);
   − n − doped thin AlGaInP barrier layer (34.2);
   − undoped GaInP active layer (35);
   − p − doped thin AlGaInP barrier layer (34.1);
   − p − doped AlGaAs cladding layer (33);
   said cladding layers (33, 36) being substantially thicker than said barrier layers (34.1, 34.2) such that said cladding layers (33, 36) provide for formation of an optical light waveguide.

6. Semiconductor diode of claims 1, 2 or 3, characterized in that it comprises the following stacked layers, ordered by their sequence:
   − p − doped AlGaAs cladding layer;
   − p − doped thin AlGaInP barrier layer:
   − undoped GaInP active layer;
   − n − doped thin AlGaInP barrier layer;
   − n − doped AlGaAs cladding layer;
   said cladding layers being substantially thicker than said barrier layers such that said cladding layers provide for formation of an optical light waveguide.

7. Semiconductor diode (70) of claim 1, 2 or 3, characterized in that it comprises the following stacked layers, ordered by their sequence:
   − n − doped AlGaAs cladding layer (77);
   − n − doped thin AlGaInP barrier layer (74.2);
   − slightly n − doped or undoped AlGaInP waveguide layer (75.3);

- undoped GaInP active layer (76.2);
- undoped AlGaInP quantum barrier layer (75.2):
- undoped GaInP active layer (76.1);
- slightly p – doped or undoped AlGaInP waveguide layer (75.1);
- p – doped thin AlGaInP barrier layer (74.1);
- p – doped AlGaAs cladding layer (73),

said cladding layers (73, 77) being substantially thicker than said barrier layers (74.1, 74.2) such that said cladding layers (73, 77) provide for formation of an optical light waveguide.

8. Semiconductor diode of claims 1, 2 or 3, characterized in that it comprises the following stacked layers, ordered by their sequence:
- p – doped AlGaAs cladding layer;
- p – doped thin AlGaInP barrier layer;
- slightly p – doped or undoped AlGaInP waveguide layer;
- undoped GaInP active layer;
- undoped AlGaInP quantum barrier layer;
- undoped GaInP active layer;
- slightly n – doped or undoped AlGaInP waveguide layer;
- n – doped thin AlGaInP barrier layer;
- n – doped AlGaAs cladding layer,

said cladding layers being substantially thicker than said barrier layers such that said cladding layers provide for formation of an optical light waveguide.

9. Semiconductor diode (30; 70; 100; 110) of claim 1, characterized in that said barrier layer (34.1, 34.2; 74.1, 74.2; 106.1, 106.2: 116.1, 116.2) has a thickness between 0,01 $\mu$m – 0,1 $\mu$m.

10. Semiconductor diode of claim 1, characterized in that said barrier layer has a graded bandgap.

11. Semiconductor diode of claim 1, characterized in that said barrier layer is a strained layer.

12. Semiconductor diode of claim 1, characterized in that said barrier layer is a disordered layer, the Ga and in atoms being randomly distributed on the sublattice.

13. Semiconductor diode of any of the preceding claims, characterized in that said semiconductor diode is a laser diode.

14. Semiconductor diode of any of the claims 1 – 11, characterized in that said semiconductor diode is a light emitting diode (LED).

FIG. 1A

FIG. 1B

FIG. 2A

p-GaAs
p-GaInP
p-AlGaInP
AlGaInP
GaInP
AlGaInP
GaInP
AlGaInP
n-AlGaInP
n-GaInP
n-GaAs

FIG. 2B

p-GaAs
p-GaInP
p-AlGaInP
AlGaInP
GaInP
AlGaInP
GaInP
AlGaInP
n-AlGaInP
n-GaInP
n-GaAs

| | |
|---|---|
| 39.1 | |
| 31 | p-GaAs |
| 32 | p-AlGaAs |
| 33 | p-AlGaAs |
| 34.1 | p-AlGaInP |
| 35 | GaInP |
| 34.2 | n-AlGaInP |
| 36 | n-AlGaAs |
| 37 | n-AlGaAs |
| 38 | n-GaAs |
| 39.2 | |

FIG. 3A

p-GaAs

p-AlGaAs

p-AlGaAs

p-AlGaInP
GaInP
n-AlGaInP

n-AlGaAs

n-AlGaAs

n-GaAs

FIG. 3B

FIG. 4

$(Al_xGa_{1-x})_yIn_{1-y}P$

FIG. 5

FIG. 6

**70** 69.1

71 — p-GaAs
72 — p-AlGaAs
73 — p-AlGaAs
74.1 — p-AlGaInP
75.1 — p-AlGaInP
76.1 — GaInP
75.2 — AlGaInP
76.2 — GaInP
75.3 — n-AlGaInP
74.2 — n-AlGaInP
77 — n-AlGaAs
78 — n-AlGaAs
79 — n-GaAs

69.2

FIG. 7A

p-GaAs

p-AlGaAs

p-AlGaAs

p-AlGaInP

p-AlGaInP

GaInP

AlGaInP

GaInP
n-AlGaInP

n-AlGaInP

n-AlGaAs
n-AlGaAs

n-GaAs

FIG. 7B

FIG. 8

FIG. 9

FIG. 10

EP 0 540 799 A1

110

112

113

111

Ti/Pt/Au

p-GaInAs

p-InP

114

p-InP

115

116.1

117

116.2

118

Si₃N₄

p-AlGaInAs

active region

n-AlGaInAs

n-InP

FIG. 11

FIG. 12

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 438 446 (WON-TIEN TSANG)<br><br>* column 2, line 40 - line 67 *<br>* column 3, line 59 - column 4, line 40 *<br>* column 5, line 7 - line 63 *<br>* column 6, line 33 - line 41; claims; figures * | 1,5,6, 12,13,16 | H01L33/00<br>H01S3/19 |
| Y | | 1,2,5,6, 8,9,12, 13,16 | |
| X | EP-A-0 213 705 (SHARP KABUSHIKI KAISHA)<br><br>* page 4, line 6 - line 12 *<br>* page 5, line 16 - line 27 *<br>* page 6, line 10 - line 34; figures 1,3 * | 1,3,4,6, 12,16 | |
| X | US-A-4 328 469 (DONALD R. SCIFRES ET AL.)<br><br>* column 4, line 7 - line 25 *<br>* column 4, line 42 - column 5, line 30 *<br>* column 6, line 16 - line 18 *<br>* column 11, line 28 - line 58; figures * | 1,5,6, 12,13,16 | |
| X | EP-A-0 348 941 (NEC CORPORATION)<br><br>* column 5, line 34 - column 6, line 9 *<br>* column 7, line 44 - column 8, line 14; claims; figure 4 * | 1,2,5, 12,16 | TECHNICAL FIELDS SEARCHED (Int. Cl.5)<br><br>H01L<br>H01S |
| X | US-A-5 048 037 (SATOSHI ARIMOTO AND TOSHITAKA AOYAGI)<br>* column 3, line 4 - line 20 *<br>* column 3, line 47 - column 4, line 26; figures 1,2 * | 1,2,5,6, 12,16 | |
| Y | | 1,2,5,6, 8,9,12, 13,16 | |

-/--

The present search report has been drawn up for all claims

| Place of search | Date of completion of the search | Examiner |
|---|---|---|
| THE HAGUE | 30 JUNE 1992 | DE LAERE A.L. |

EPO FORM 1503 03.82 (P0401)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-5 048 036 (DONALD R. SCIFRES ET AL.)<br><br>* column 5, line 50 - column 6, line 43 *<br>* column 7, line 14 - line 40; figure 2 *<br>--- | 1-7,<br>12-14,<br>16-17 | |
| D,A | JAPANESE JOURNAL OF APPLIED PHYSICS.<br>vol. 29, no. 9, September 1990, TOKYO JP<br>pages 1666 - 1668;<br>YOSHIYASU UENO ET AL.: 'Novel window-structure AlGaInP visible-light laser diodes with non-absorbing facets fabricated by utilizing GaInP natural superlattice disordering'<br>* the whole document *<br><br>----- | 1,15 | |
| | | | TECHNICAL FIELDS SEARCHED (Int. Cl.5) |

The present search report has been drawn up for all claims

| Place of search | Date of completion of the search | Examiner |
|---|---|---|
| THE HAGUE | 30 JUNE 1992 | DE LAERE A.L. |

EPO FORM 1503 03.82 (P0401)